# EUROPÄISCHE PATENTSCHRIFT

(11) **EP 1 391 035 B1**
(45) Veröffentlichungstag und Bekanntmachung des Hinweises auf die Patenterteilung: **29.09.2004**
(21) Anmeldenummer: 02735233.5
(22) Anmeldetag: 18.04.2002
(51) Int. Cl.: H03G 1/00

(54) **SCHALTUNGSANORDNUNG MIT KASKADIERTEN FELDEFFEKTTRANSISTOREN**
CIRCUIT ARRANGEMENT COMPRISING CASCADED FIELD EFFECT TRANSISTORS
CIRCUIT COMPORTANT DES TRANSISTORS A EFFET DE CHAMP EN CASCADE

(30) Priorität: 14.05.2001 DE 10123395
(43) Veröffentlichungstag der Anmeldung: 25.02.2004
(73) Patentinhaber: Infineon Technologies AG, 81669 München (DE)
(72) Erfinder: ZIMMERMANN, Walter, 84405 Dorfen (DE)
(74) Vertreter: Zimmermann & Partner
(86) Internationale Anmeldenummer: PCT/EP2002/003867
(87) Internationale Veröffentlichungsnummer: WO 2002/093734

(56) Entgegenhaltungen:
- DE-A- 4 134 177
- US-A- 5 337 019

## Beschreibung

Die vorliegende Erfindung betrifft eine Schaltungsanordnung mit kaskadierten Feldeffekttransistoren. Die vorliegende Erfindung betrifft insbesondere eine Schaltungsanordnung mit kaskadierten Feldeffekttransistoren für Hochfrequenz-Anwendungen.

Schaltungsanordnung mit kaskadierten Feldeffekttransistoren, beispielsweise Tetroden oder Pentoden, werden häufig als steuerbare Verstärker für Hochfrequenz-Anwendungen eingesetzt. Die kaskadierten Feldeffekttransistoren besitzen mehrere Gate-Anschlüsse, wobei in der Regel das zu verarbeitenden Signal an einem ersten Gate angelegt wird während ein zweites Gate zur Steuerung der Verstärkung dient. Die Steuerung soll dabei ein großes Verstärkungsinterval überstreichen (z.B. 70dB). Eine derartige Schaltungsanordnung ist beispielsweise in der Druckschrift DE 41 34 177 gezeigt.

Die Verstärkungsregelung von MOS-Tetroden/Pentoden erfolgt in der Regel über eine Abregelung der Spannung, welche an dem zweiten Gate angelegt wird. Ein linearisierter Regelverlauf, ein hoher Regelhub und geringere Intermodulations-Verzerrungen werden erreicht, wenn einhergehend mit der Abregelung der Spannung, welche an dem zweiten Gate angelegt wird, das Potential an dem ersten Gate aufgeregelt wird. In früheren Schaltungsanordnungen mit kaskadierten Feldeffekttransistoren, beispielsweise Tunerschaltungen für Fernsehempfänger, wurde dies mit einer Schaltung zur Stabilisierung des Betriebsstroms erreicht, welche üblicherweise einen Source-Widerstand umfaßte.

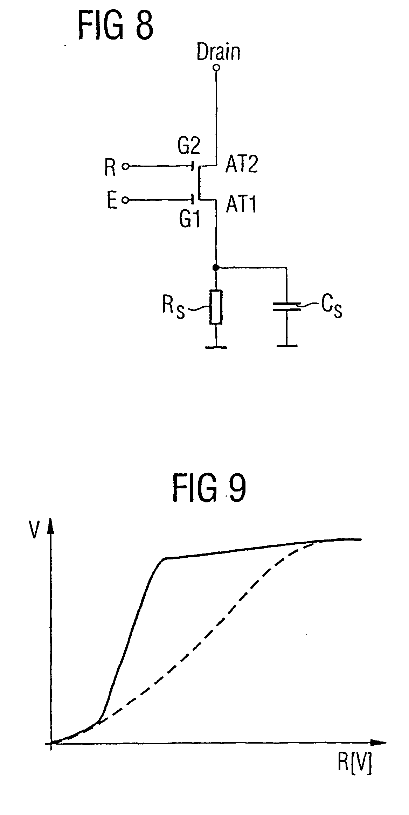

Fig. 8 zeigt schematisch eine derartige Schaltungsanordnung, welche zwei kaskadierte Feldeffekttransistoren AT1 und AT2 sowie einen Source-Widerstand Rₛ und einen Kondensator Cₛ zur Hochfrequenz-Blockung umfaßt. Das zu verstärkende Signal E wird mit der Gate-Elektrode G1 des ersten Feldeffekttransistors AT1 verbunden während die Steuerung der Verstärkung über ein Signal R erfolgt, das an die Gate-Elektrode G2 des zweiten Feldeffekttransistors AT2 angelegt wird. Der zusätzliche Source-Widerstand Rₛ verringerte zwar die nutzbare Versorgungsspannung um etwa 3 Volt. Dieser Nachteil konnte jedoch in Kauf genommen werden, da diese Schaltungen üblicherweise mit Versorgungsspannungen von 9 bis 12 Volt betrieben wurden. Fig. 9 zeigt das Verhalten dieser Schaltung am Beispiel der Verstärkung der Schaltung in Abhängigkeit von der an die Gate-Elektrode G2 angelegte Spannung (gestrichelte Linie). Man erkennt, daß sich die Verstärkung der Schaltung über einen relativ weiten Bereich weitgehend linear mit der an die Gate-Elektrode G2 angelegte Spannung regeln läßt.

Bei der modernen elektronischen Signalverarbeitung werden immer kleinere Betriebsspannungen verwendet. Dies hat wiederum zur Folge, daß ein Source-Widerstand Rₛ, wie er in Fig. 8 gezeigt ist, in modernen Schaltungsanordnungen nicht eingesetzt werden kann, da ansonsten ein zu geringer Anteil der Versorgungsspannung für die zwei kaskadierten Feldeffekttransistoren AT1 und AT2 zur Verfügung steht. Aufgrund des fehlenden Source-Widerstandes Rₛ wird jedoch nun der wesentliche Regelbereich allein von den Transistoreigenschaften bestimmt.

Fig. 9 zeigt das Verhalten einer derartigen Schaltung ohne Source-Widerstand Rₛ (durchgezogene Linie). Ausgehend vom einem aufgeregeltem Zustand erfolgt die Abregelung anfänglich sehr moderat, um anschließend in einen kurzen und steilen Abfall überzugehen. Dementsprechend erfolgt die eigentliche Regelung der Verstärkung über ein relativ kleines Intervall für die an die Gate-Elektrode G2 angelegte Spannung. Aufgrund des kurzen und steilen Abfalls der Verstärkung wird es jedoch immer schwieriger, die Schaltung innerhalb eines vollständigen Regelkreises zur Kontrolle der Signalverstärkung einzusetzen, da in dem Bereich des kurzen und steilen Abfalls bereits kleine Änderungen der an die Gate-Elektrode G2 angelegten Spannung und geringe Abweichungen in den Transistoreigenschaften zu drastischen Veränderungen der Verstärkung der Regelspur führen. Zunehmend verfeinerte Transistoren und die Tendenz zu kleineren Betriebsspannungen verstärken diese Eigenschaften.

Aufgabe der Erfindung ist es daher, eine Schaltungsanordnung mit kaskadierten Feldeffekttransistoren anzugeben, welche die genannten Probleme vermindert bzw. ganz vermeidet. Aufgabe der Erfindung ist es insbesondere, eine Schaltungsanordnung mit kaskadierten Feldeffekttransistoren anzugeben, die zwischen einem definierten Start- und Endpunkt einen gestreckten und linearisierten Regelverlauf gewährleistet.

Die Aufgabe wird durch eine Schaltungsanordnung mit zumindest zwei kaskadierten Feldeffekttransistoren gemäß Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird eine Schaltungsanordnung mit zumindest zwei kaskadierten Feldeffekttransistoren, insbesondere für Hochfrequenz-Anwendungen, bereitgestellt, die einen Source-Anschluß, einen Drain-Anschluß, zumindest einen Eingangssignal-Anschluß, welcher mit der Gate-Elektrode eines ersten Arbeitstransistors verbunden ist, und zumindest einen Regelspannungs-Anschluß aufweist, welcher mit der Gate-Elektrode eines zweiten Arbeitstransistors verbunden ist. Die erfindungsgemäße Schaltungsanordnung ist dadurch gekennzeichnet, daß ein Spannungsteiler, welcher zwischen dem Regelspannungs-Anschluß und der Gate-Elektrode des zweiten Arbeitstransistors angeordnet ist, eine erste Schaltungseinheit, welche mit dem Regelspannungs-Anschluß verbunden ist und welche oberhalb einer ersten, vorgegebenen Schwellspannung den Spannungsteiler wirksam werden läßt, und eine zweite Schaltungseinheit, welche mit dem Regelspannungs-Anschluß verbunden ist und welche oberhalb einer'zweiten, vorgegebenen Schwellspannung, die größer als die erste Schwellspannung ist, den Spannungsteiler unwirksam werden läßt, vorgesehen sind.

Die erfindungsgemäße Schaltungsanordnung besitzt somit den Vorteil, daß die Streckung der Regelspur nach einer definierbaren Schwelle einsetzt und die endgültige Aufregelung auf ein kleines Intervall komprimiert wird. Dementsprechend erfolgt die eigentliche Regelung der Verstärkung über ein deutlich vergrößertes Intervall, wodurch die erfindungsgemäße Schaltungsanordnung auf relativ einfache Weise innerhalb eines vollständigen Regelkreises zur verbesserten Kontrolle der Signalverstärkung eingesetzt werden kann.

Die erfindungsgemäße Schaltungsanordnung besitzt darüber hinaus den Vorteil, daß sie in ihrer Dimensionierung in einfacher Weise an die Eigenschaften der kaskadierten Arbeitstransistoren und an die Erfordernisse der jeweiligen Anwendung angepaßt werden kann.

In einer bevorzugten Ausführung umfaßt der Spannungsteiler einen ersten Arm mit zumindest einem ersten Widerstand und einen zweiten Arm mit zumindest einem zweiten Widerstand, wobei die Gate-Elektrode des zweiten Arbeitstransistors mit einem Anschluß, der zwischen dem ersten und dem zweiten Arm des Spannungsteilers angeordnet ist, und der Regelspannungs-Anschluß mit dem zweiten Arm des Spannungsteilers verbunden ist.

In einer weiteren bevorzugten Ausführung ist als erste Schaltungseinheit ein erster Steuertransistor vorgesehen, der in dem ersten Arm des Spannungsteilers in Reihe zu dem ersten Widerstand geschaltet ist. Dabei ist es insbesondere bevorzugt, wenn der erste Steuertransistor die selbe Schwellenspannung wie der zweite Arbeitstransistor aufweist. Weiterhin ist es bevorzugt, wenn der Drain-Anschluß des ersten Steuertransistors und die Gate-Elektrode des ersten Steuertransistors verbunden sind.

In einer weiteren bevorzugten Ausführung weist die zweite Schaltungseinheit zumindest einen zweiten Steuertransistor auf, der in dem zweiten Arm des Spannungsteilers parallel zu dem zweiten Widerstand geschaltet ist. Dabei ist es insbesondere bevorzugt, wenn der zweite Steuertransistor ein p-Kanal Transistor vom Typ "normaly off" ist.

In einer weiteren bevorzugten Ausführung weist die zweite Schaltungseinheit zumindest einen zweiten Steuertransistor auf, der in dem ersten Arm des Spannungsteilers in Reihe zu dem ersten Widerstand geschaltet ist. Dabei ist es insbesondere bevorzugt, wenn der zweite Steuertransistor ein n-Kanal Transistor vom Typ "normaly on" ist.

In einer weiteren bevorzugten Ausführung ist der Regelspannungs-Anschluß zusätzlich über einen Kondensator mit der Gate-Elektrode des zweiten Arbeitstransistors verbunden. Weiterhin ist es bevorzugt, wenn eine Biasingschaltung für die Gate-Elektrode des ersten Arbeitstransistors vorgesehen ist. Dabei ist es insbesondere bevorzugt, wenn die Biasingschaltung zumindest zwei kaskadierte Feldeffekttransistoren aufweist, deren Gate-Elektroden mit den Gate-Elektroden der ersten bzw. zweiten Arbeitstransistoren verbunden sind.

Die Erfindung wird nachfolgend anhand von Figuren der Zeichnung näher dargestellt. Es zeigen:
- Fig. 1: eine erste Ausführungsform einer erfindungsgemäßen Schaltungsanordnung,
- Fig. 2: den Verlauf der Verstärkung in Abhängigkeit von der Regelspannung,
- Fig. 3: eine zweite Ausführungsform einer erfindungsgemäßen Schaltungsanordnung,
- Fig. 4: eine weitere Ausführungsform einer erfindungsgemäßen Schaltungsanordnung,
- Fig. 5: eine weitere Ausführungsform einer erfindungsgemäßen Schaltungsanordnung,
- Fig. 6: eine weitere Ausführungsform einer erfindungsgemäßen Schaltungsanordnung,
- Fig. 7: eine weitere Ausführungsform einer erfindungsgemäßen Schaltungsanordnung,
- Fig. 8: eine Ausführungsform einer Schaltungsanordnung nach dem Stand der Technik, und
- Fig. 9: Verhalten einer Schaltungsanordnung nach dem Stand der Technik ohne Source-Widerstand Rₛ (durchgezogene Linie) bzw. mit Source-Widerstand Rₛ (gestrichelte Linie),

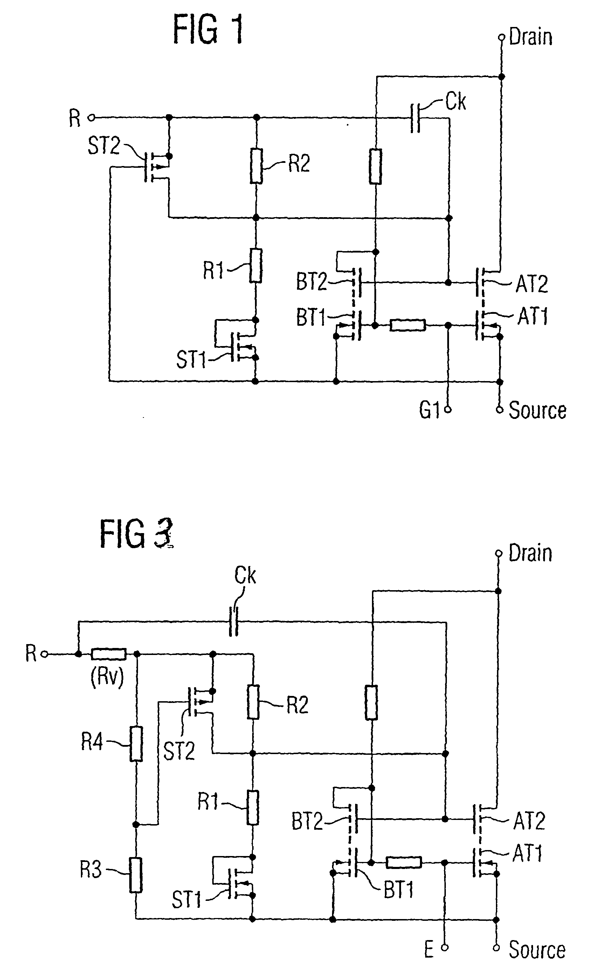

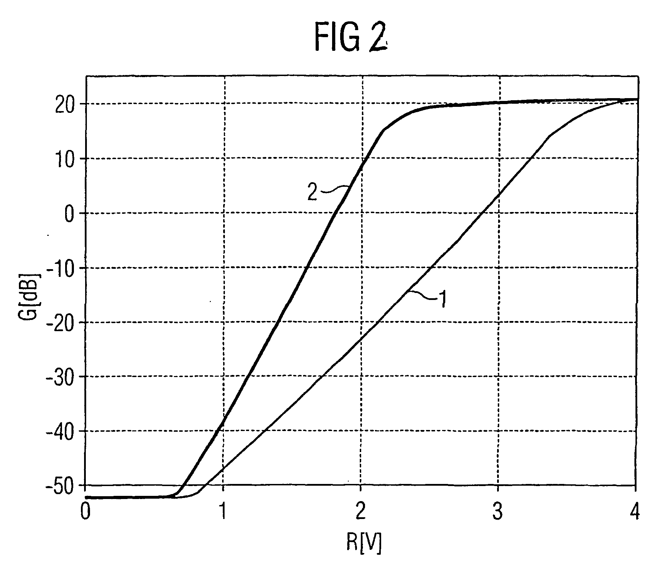

Figur 1 zeigt eine Ausführungsform einer erfindungsgemäßen Schaltungsanordnung. Dabei umfaßt die in Fig. 1 gezeigte Schaltungsanordnung zwei kaskadierte Feldeffekttransistoren AT1 und AT2, die zwischen einem Source-Anschluß und einem Drain-Anschluß angeordnet sind. Weiterhin ist ein Eingangssignal-Anschluß E vorgesehen, welcher mit der Gate-Elektrode des ersten Arbeitstransistors AT1 verbunden ist. Entsprechend ist ein Regelspannungs-Anschluß R vorgesehen, welcher mit der Gate-Elektrode des zweiten Arbeitstransistors AT2 verbunden ist.

Die Widerstände R1 und R2 bilden einen Spannungsteiler, welcher zwischen dem Regelspannungs-Anschluß R und der Gate-Elektrode des zweiten Arbeitstransistors AT2 angeordnet ist. Der Spannungsteiler umfaßt somit einen ersten Arm mit dem ersten Widerstand R1 und einen zweiten Arm mit dem zweiten Widerstand R2, wobei die Gate-Elektrode des zweiten Arbeitstransistors AT2 mit einem Anschluß, der zwischen dem ersten und dem zweiten Arm des Spannungsteilers angeordnet ist, und der Regelspannungs-Anschluß R mit dem zweiten Arm des Spannungsteilers verbunden ist.

Weiterhin ist eine erste Schaltungseinheit vorgesehen, welche über die Widerstände R1 und R2 mit dem Regelspannungs-Anschluß R verbunden ist und welche oberhalb einer ersten, vorgegebenen Schwellspannung den Spannungsteiler wirksam werden läßt. In der in Fig. 1 gezeigten Ausführungsform ist als erste Schaltungseinheit ein erster Steuertransistor ST1 vorgesehen, der in dem ersten Arm des Spannungsteilers in Reihe zu dem ersten Widerstand R1 geschaltet ist, wobei der Drain-Anschluß des ersten Steuertransistors ST1 und die Gate-Elektrode des ersten Steuertransistors ST1 verbunden sind. Weiterhin weist der erste Steuertransistor ST1 die selbe Schwellenspannung wie der zweite Arbeitstransistor AT2 auf.

Darüber hinaus ist eine zweite Schaltungseinheit vorgesehen, welche mit dem Regelspannungs-Anschluß R verbunden ist und welche oberhalb einer zweiten, vorgegebenen Schwellenspannung, die größer als die erste Schwellenspannung ist, den Spannungsteiler unwirksam werden läßt. In der in Fig. 1 gezeigten Ausführungsform weist die zweite Schaltungseinheit einen zweiten Steuertransistor ST2 auf, der in dem zweiten Arm des Spannungsteilers parallel zu dem zweiten Widerstand R2 geschaltet ist. In diesem Beispiel ist zweite Steuertransistor ST2 ein p-Kanal Transistor vom Typ "normaly off".

Weiterhin ist eine Biasingschaltung für die Gate-Elektrode des ersten Arbeitstransistors AT1 vorgesehen. In der in Fig. 1 gezeigten Ausführungsform weist die Biasingschaltung zwei kaskadierte Feldeffekttransistoren BT1 und BT2 auf, deren Gate-Elektroden mit den Gate-Elektroden der ersten bzw. zweiten Arbeitstransistoren AT1 bzw. AT2 verbunden sind. Die kaskadierten Feldeffekttransistoren BT1 und BT2 sind parallel zu den kaskadierten Arbeitstransistoren AT1 und AT2 zwischen dem Source- und dem Drain-Anschluß angeordnet. Zur Verbesserung der Verstärkungs-, Rückwirkungsund Überkoppelungseigenschaften ist der Regelspannungs-Anschluß R zusätzlich über einen Kondensator Ck mit der Gate-Elektrode des zweiten Arbeitstransistors AT2 verbunden.

Die folgenden Ausführungen betrachten den Regelverlauf immer ausgehend vom voll abgeregelten Zustand in Richtung Aufregelung, d.h. im Folgenden wird das Verhalten in Abhängigkeit von einer anwachsenden Regelspannung an dem Regelspannungs-Anschluß R beschrieben. Der ersten Steuertransistors ST1, der die selbe Schwellenspannung wie der zweite Arbeitstransistor AT2 aufweist, läßt den Spannungsteiler erst ab dieser Schwellenspannung wirksam werden. Bis dahin wird die steuernde Spannung unverändert zur Gate-Elektrode des zweiten Arbeitstransistors AT2 geführt. So werden weder die Einsatzspannung für die Regelung noch Streuungen in den Schwellenspannungen gedehnt wirksam. Im anschließenden Bereich der Aufsteuerung des zweiten Arbeitstransistors AT2 mit dem an sich steilen Teil der Regelspur wird der Spannungsteiler wirksam und expandiert den Verlauf im Verhältnis R1/(R1 + R2).

Erreicht die Regelspannung an dem Regelspannungs-Anschluß R die zweite Schwellenspannung, so wird der zweite Steuertransistor ST2 aktiv. Dies hat zur Folge, daß der zweite Steuertransistor ST2 den zweiten Widerstand R2 überbrückt und somit außer Funktion setzt. Dementsprechend wird auch der Spannungsteiler als Ganzes unwirksam und die Regelspannung wird wieder im wesentlichen unverändert zur Gate-Elektrode des zweiten Arbeitstransistors AT2 geführt. Dementsprechend wird der anschließende, flach ansteigende Teil der Regelspur gegenüber der herkömmlichen Regelung stark verkürzt. Damit verbunden ist eine Lasterhöhung für die Regelspannung, was wiederum mit dem Vorteil verbunden ist, daß es zu einer gegenkoppelnden Wirkung auf das Gesamtsystem kommt, die Steuerschwelle des Steuertransistors ST2 also nicht abrupt wirksam wird. Der entsprechende Verlauf der Verstärkung in Abhängigkeit von der Regelspannung ist in Fig. 2 gezeigt. Dabei zeigt die Kurve 1 den Verlauf der Verstärkung, der sich mit der erfindungsgemäßen Schaltungsanordnung einstellt, während Kurve 2 dem Verlauf der Verstärkung zeigt, der sich bei Schaltungsanordnung nach dem Stand der Technik einstellt.

Fig. 3 zeigt eine zweite Ausführungsform einer erfindungsgemäßen Schaltungsanordnung. Die zweite Ausführungsform entspricht im wesentlichen der ersten Ausführungsform mit Ausnahme der folgenden Unterschiede. Zusätzlich zu dem zweiten Steuertransistor ST2, der in dem zweiten Arm des Spannungsteilers parallel zu dem zweiten Widerstand R2 geschaltet ist, weist die zweite Schaltungseinheit bei der in Fig. 3 gezeigten Ausführungsform einen zweiten Spannungsteiler auf, der von den Widerständen R3 und R4 gebildet wird. Der zweite Spannungsteiler ist dabei zwischen der Gate-Elektrode des zweiten Steuertransistor ST₂ und dem Regelspannungs-Anschluß R angeordnet. Somit kann die Schwellenspannung für die zweite Schaltungseinheit über den zweiten Spannungsteiler eingestellt werden.

Optional kann ein weiterer Widerstand Rv vor dem zweiten Spannungsteiler vorgesehen sein. Bei einer sehr niederohmigen Quellen-Impedanz kann die Kompressionsphase mit diesem Widerstand Rv gestreckt werden.

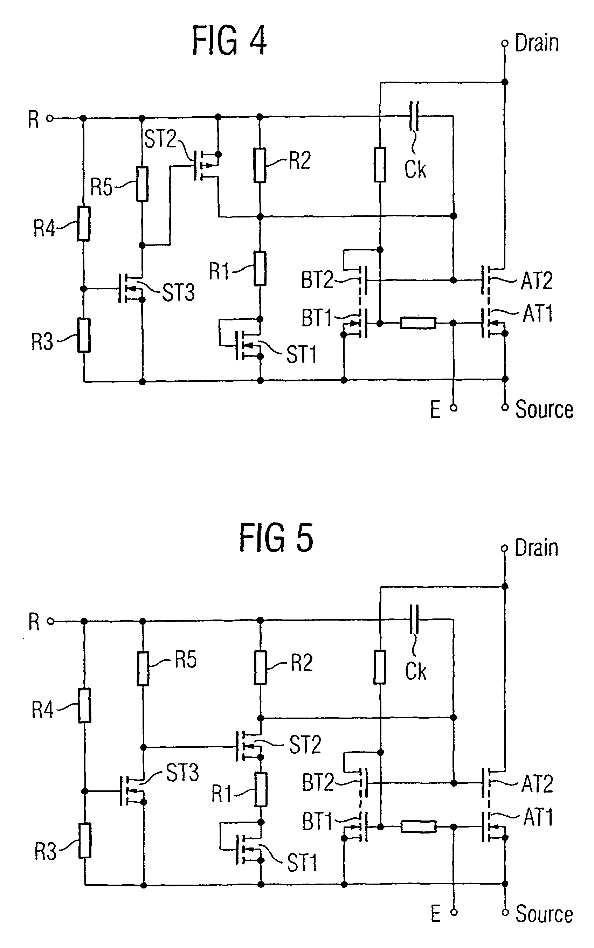

Fig. 4 zeigt eine weitere Ausführungsform einer erfindungsgemäßen Schaltungsanordnung. Die weitere Ausführungsform entspricht im wesentlichen der zweiten Ausführungsform mit Ausnahme der folgenden Unterschiede. Zusätzlich zu dem zweiten Steuertransistor ST2 und dem zweiten Spannungsteiler, der von den Widerständen R3 und R4 gebildet wird, weist die zweite Schaltungseinheit bei der in Fig. 4 gezeigten Ausführungs form einen weiteren Steuertransistor ST3 sowie einen weiteren Widerstand R5 auf.

Durch eine Erhöhung der Regelspannung wird der Steuertransistor ST3 aufgesteuert, wodurch wiederum der zweite Steuertransistor ST2 leitend wird. Die Einsatzspannung des weiteren Steuertransistor ST3 multipliziert mit dem Teilerverhältnis R4/(R4 + R3) des zweiten Spannungsteilers bestimmt somit die Schwellenspannung für die zweite Schaltungseinheit. Die Schwelle für Steuertransistors ST3 sollte dabei möglichst hoch liegen, um den Multiplikationfaktor R4/(R3+R4) klein zu halten (Multiplikation der Toleranzen).

Fig. 5 zeigt eine weitere Ausführungsform einer erfindungsgemäßen Schaltungsanordnung. Im Gegensatz zu den bisher gezeigten Ausführungsformen weist die zweite Schaltungseinheit bei der in Fig. 5 gezeigten Ausführungsform einen zweiten Steuertransistor ST2 auf, der in dem ersten Arm des Spannungsteilers in Reihe zu dem ersten Widerstand R1 geschaltet ist. Bei dieser Ausführungsform ist der zweite Steuertransistor ST2 ein selbstleitender n-Kanal Transistor vom Typ "normaly on".

Durch eine Erhöhung der Regelspannung wird der Steuertransistor ST3 aufgesteuert, wodurch wiederum der zweite Steuertransistor ST2 nicht-leitend wird. Dementsprechend wird der erste Arm des ersten Spannungsteilers unwirksam und die Regelspannung wird wiederum im wesentlichen unverändert zu Gate-Elektrode G2 des zweiten Arbeitstransistors AT2 geführt. Wiederum bestimmt somit die Einsatzspannung des weiteren Steuertransistor ST3 multipliziert mit dem Teilerverhältnis R4/(R4 + R3) des zweiten Spannungsteilers die Schwellenspannung für die zweite Schaltungseinheit.

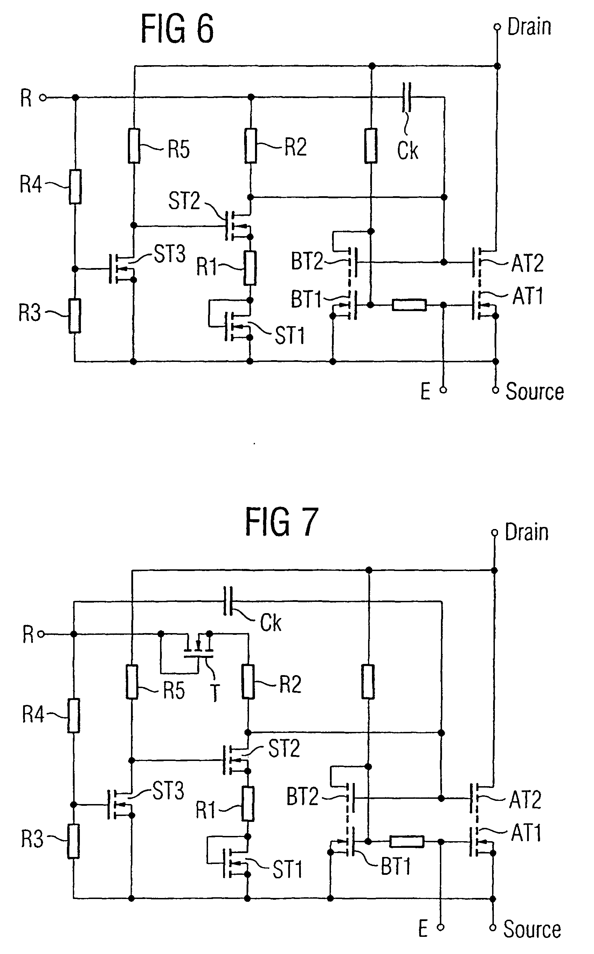

Fig. 6 zeigt eine weitere Ausführungsform einer erfindungsgemäßen Schaltungsanordnung. Die weitere Ausführungsform entspricht im wesentlichen der in Fig. 5 gezeigten Ausführungsform mit Ausnahme der folgenden Unterschiede. Anstatt eines selbstleitenden n-Kanal Transistors vom Typ "normaly on" wird bei dieser ein n-Kanal Transistor vom Typ "normaly off" als der zweite Steuertransistor ST2 eingesetzt. Weiterhin ist der Widerstand R5 in dieser Ausführungsform nicht direkt mit dem Regelspannungs-Anschluß R sondern mit dem Drain-Anschluß verbunden.

Durch eine Erhöhung der Regelspannung wird der Steuertransistor ST3 aufgesteuert, wodurch wiederum der zweite Steuertransistor ST2 sperrend wird. Dementsprechend wird der erste Arm des ersten Spannungsteilers unwirksam und die Regelspannung wird wiederum im wesentlichen unverändert zu Gate-Elektrode G2 des zweiten Arbeitstransistors AT2 geführt. Damit dies moderat geschieht, ist der zweite Steuertransistor ST2 in den ersten Arm des ersten Spannungsteiler zwischen R1 und R2 eingefügt. Der Widerstand R1 an der Source des Steuertransistors ST2 wirkt dabei stark gegenkoppelnd und verhindert damit eine abrupte Übergabe. Die Schwelle für Steuertransistors ST3 sollte möglichst hoch liegen, um den Multiplikationfaktor R4/(R3+R4) klein zu halten (Multiplikation der Toleranzen). Da der Betriebstransistors AT1 wegen der Biasingschaltung eine allgemein höhere Schwelle hat, wird auch für den Steuertransistors ST2 zweckmäßigerweise diese Implantation verwendet. Selbstverständlich sind auch höhere Schwellwerte durch kombinierte oder andere Implantationen möglich.

Fig. 7 zeigt eine weitere Ausführungsform einer erfindungsgemäßen Schaltungsanordnung. Die weitere Ausführungsform entspricht im wesentlichen der in Fig. 6 gezeigten Ausführungsform mit Ausnahme des folgenden Unterschieds. Die in Fig. 7 gezeigte Schaltungsanordnung unterscheidet sich von der in Fig. 6 gezeigten Schaltungsanordnung durch einen zusätzlichen Spannungs-Offset in der Ansteuerung der Gate-Elektrode G2 des zweiten Arbeitstransistors AT2. Besitzt der Arbeitstransistor AT2 beispielsweise eine sehr niedriger Einsatzspannung und am Bauelement soll jedoch eine deutlich höhere Einsatzspannung gewährleistet werden, so kann dies durch einen zusätzlichen Transistor T erreicht werden.

Die erfindungsgemäße Schaltungsanordnung basiert auf der Streckung der Regelspur durch einen Spannungsteiler R1 und R2, welcher die Regelspannung im Verhältnis R1 /(R1 + R2) geteilt der Gate-Elektrode des zweiten Arbeitstransistors AT2 zuführt. Diese Streckung soll aber nur den steilen Teil der Regelspur betreffen. Dementsprechend sind die erste und zweite Schaltungseinheit vorgesehen, die Einsatzspannung richtig zu legen und den langgestreckten flachen oberen Teil der Regelkennlinie stark zu verkürzen und richtig zu positionieren. Weiterhin werden Streuungen in den Einsatzspannungen möglichst abgefangen oder kompensiert, anstatt diese mit den Teilerschaltungen zu multiplizieren.

## Patentansprüche

1. Schaltungsanordnung mit zumindest zwei kaskadierten Feldeffekttransistoren, insbesondere für Hochfrequenz-Anwendungen, mit einem Source-Anschluß, einem Drain-Anschluß, zumindest einem Eingangssignal-Anschluß (E), welcher mit der Gate-Elektrode eines ersten Arbeitstransistors (AT1) verbunden ist, und zumindest einem Regelspannungs-Anschluß (R), welcher mit der Gate-Elektrode eines zweiten Arbeitstransistors (AT2) verbunden ist,
**dadurch gekennzeichnet, daß**
ein Spannungsteiler (R1, R2), welcher zwischen dem Regelspannungs-Anschluß (R) und der Gate-Elektrode des zweiten Arbeitstransistors (AT2) angeordnet ist,
eine erste Schaltungseinheit, welche mit dem Regelspannungs-Anschluß (R) verbunden ist und welche oberhalb einer ersten, vorgegebenen Schwellspannung den Spannungsteiler (R1, R2) wirksam werden läßt, und
eine zweite Schaltungseinheit, welche mit dem Regelspannungs-Anschluß (R) verbunden ist und welche oberhalb einer zweiten, vorgegebenen Schwellspannung, die größer als die erste Schwellspannung ist, den Spannungsteiler (R1, R2) unwirksam werden läßt, vorgesehen sind.

2. Schaltungsanordnung nach Anspruch 1,
**dadurch gekennzeichnet, daß**
der Spannungsteiler (R1, R2) einen ersten Arm mit zumindest einem ersten Widerstand (R1) und einen zweiten Arm mit zumindest einem zweiten Widerstand (R2) umfaßt, wobei die Gate-Elektrode des zweiten Arbeitstransistors (AT2) mit einem Anschluß, der zwischen dem ersten und dem zweiten Arm des Spannungsteilers (R1, R2) angeordnet ist, und der Regelspannungs-Anschluß (R) mit dem zweiten Arm des Spannungsteilers (R1, R2) verbunden ist.

3. Schaltungsanordnung nach Anspruch 2,
**dadurch gekennzeichnet, daß**
als erste Schaltungseinheit ein erster Steuertransistor (ST1) vorgesehen ist, der in dem ersten Arm des Spannungsteilers in Reihe zu dem ersten Widerstand (R1) geschaltet ist.

4. Schaltungsanordnung nach Anspruch 3,
**dadurch gekennzeichnet, daß**
der erste Steuertransistor (ST1) die selbe Schwellenspannung wie der zweite Arbeitstransistor (AT2) aufweist.

5. Schaltungsanordnung nach Anspruch 3 oder 4,
**dadurch gekennzeichnet, daß**
der Drain-Anschluß des ersten Steuertransistors (ST1) und die Gate-Elektrode des ersten Steuertransistors (ST1) verbunden sind.

6. Schaltungsanordnung nach einem der Ansprüche 2 bis 5,
**dadurch gekennzeichnet, daß**
die zweite Schaltungseinheit zumindest einen zweiten Steuertransistor (ST2) aufweist, der in dem zweiten Arm des Spannungsteilers parallel zu dem zweiten Widerstand (R2) geschaltet ist.

7. Schaltungsanordnung nach Anspruch 6,
**dadurch gekennzeichnet, daß**
der zweite Steuertransistor (ST2) ein p-Kanal Transistor ist.

8. Schaltungsanordnung nach einem der Ansprüche 2 bis 5,
**dadurch gekennzeichnet, daß**
die zweite Schaltungseinheit zumindest einen zweiten Steuertransistor (ST2) aufweist, der in dem ersten Arm des Spannungsteilers in Reihe zu dem ersten Widerstand (R1) geschaltet ist.

9. Schaltungsanordnung nach Anspruch 8,
**dadurch gekennzeichnet, daß**
der zweite Steuertransistor (ST2) ein n-Kanal Transistor ist.

10. Schaltungsanordnung nach einem der Ansprüche 1 bis 9,
**dadurch gekennzeichnet, daß**
der Regelspannungs-Anschluß (R) zusätzlich über einen Kondensator (Ck) mit der Gate-Elektrode des zweiten Arbeitstransistors (AT2) verbunden ist.

11. Schaltungsanordnung nach einem der Ansprüche 1 bis 10,
**dadurch gekennzeichnet, daß**
eine Biasingschaltung (BT1, BT2) für die Gate-Elektrode des ersten Arbeitstransistors (AT1) vorgesehen ist.

12. Schaltungsanordnung nach Anspruch 11,
**dadurch gekennzeichnet, daß**
die Biasingschaltung zumindest zwei kaskadierte Feldeffekttransistoren (BT1, BT2) aufweist, deren Gate-Elektroden mit den Gate-Elektroden der ersten bzw. zweiten Arbeitstransistoren (AT1, AT2)verbunden sind.

## Claims

1. A circuit arrangement comprising at least two cascaded field effect transistors, in particular for high-frequency applications, having a source terminal, a drain terminal, at least one input signal terminal (E), which is connected to the gate electrode of a first operating transistor (AT1), and at least one control voltage terminal (R), which is connected to the gate electrode of a second operating transistor (AT2), **characterized in that**
a voltage divider (R1, R2), which is arranged between the control voltage terminal (R) and the gate electrode of the second operating transistor (AT2),
a first circuit unit, which is connected to the control voltage terminal (R) and which activates the voltage divider (R1, R2) above a first, predefined threshold voltage, and
a second circuit unit, which is connected to the control voltage terminal (R) and which deactivates the voltage divider (R1, R2) above a second, predefined threshold voltage, which is higher than the first threshold voltage,
are provided.

2. The circuit arrangement as claimed in claim 1, **characterized in that** the voltage divider (R1, R2) comprises a first arm with at least one first resistor (R1) and a second arm with at least one second resistor (R2), the gate electrode of the second operating transistor (AT2) being connected to a terminal which is arranged between the first and the second arm of the voltage divider (R1, R2), and the control voltage terminal (R) being connected to the second arm of the voltage divider (R1, R2).

3. The circuit arrangement as claimed in claim 2, **characterized in that** the first circuit unit provided is a first control transistor (ST1), which is connected in the first arm of the voltage divider, in series with the first resistor (R1).

4. The circuit arrangement as claimed in claim 3, **characterized in that** the first control transistor (ST1) has the same threshold voltage as the second operating transistor (AT2).

5. The circuit arrangement as claimed in claim 3 or 4, **characterized in that** the drain terminal of the first control transistor (ST1) and the gate electrode of the first control transistor (ST1) are connected.

6. The circuit arrangement as claimed in one of claims 2 to 5, **characterized in that** the second circuit unit has at least one second control transistor (ST2), which is connected in the second arm of the voltage divider, parallel to the second resistor (R2).

7. The circuit arrangement as claimed in claim 6, **characterized in that** the second control transistor (ST2) is a p-channel transistor.

8. The circuit arrangement as claimed in one of claims 2 to 5, **characterized in that** the second circuit unit has at least one second control transistor (ST2), which is connected in the first arm of the voltage divider, in series with the first resistor (R1).

9. The circuit arrangement as claimed in claim 8, **characterized in that** the second control transistor (ST2) is an n-channel transistor.

10. The circuit arrangement as claimed in one of claims 1 to 9, **characterized in that** the control voltage terminal (R) is additionally connected via a capacitor (Ck) to the gate electrode of the second operating transistor (AT2).

11. The circuit arrangement as claimed in one of claims 1 to 10, **characterized in that** a bias circuit (BT1, BT2) for the gate electrode of the first operating transistor (AT1) is provided.

12. The circuit arrangement as claimed in claim 11, **characterized in that** the bias circuit has at least two cascaded field effect transistors (BT1, BT2), whose gate electrodes are connected to the gate electrodes of the first and second operating transistors (AT1, AT2), respectively.

## Revendications

1. Circuit comprenant au moins deux transistors à effet de champ en cascade, notamment pour des applications en hautes fréquences, ayant une borne de source, une borne de drain, au moins une borne (E) de signal d'entrée, qui est reliée à l'électrode de grille d'un premier transistor (AT1) de travail, et au moins une borne (R) de tension de régulation, qui est reliée à l'électrode de grille d'un deuxième transistor (AT2) de travail,
**caractérisé en ce qu'**il est prévu,
un diviseur (R1, R2) de tension, qui est monté entre la borne (R) de tension de régulation et l'électrode de grille du deuxième transistor(AT2) de travail,
une première unité de circuit, qui est reliée à la borne (R) de tension de régulation et qui peut rendre efficace le diviseur (R1, R2) de tension au-dessus d'une première tension de seuil donnée à l'avance, et
une deuxième unité de circuit, qui est reliée à la borne (R) de tension de régulation et qui peut rendre inefficace le diviseur (R1, R2) de tension au-dessus d'une deuxième tension de seuil qui est donnée à l'avance et qui est plus haute que la première tension de seuil.

2. Circuit suivant la revendication 1, **caractérisé en ce que** le diviseur (R1, R2) de tension comprend une première branche ayant au moins une première résistance (R1) et une deuxième branche ayant au moins une deuxième résistance (R2), l'électrode de grille du deuxième transistor (AT2) de travail étant reliée à une borne qui est montée entre la première branche et la deuxième branche du diviseur (R1, R2) de tension et la borne (R) de tension de régulation étant reliée à la deuxième branche du diviseur (R1, R2) de tension.

3. Circuit suivant la revendication 2, **caractérisé en ce qu'**il est prévu, comme première unité de circuit, un premier transistor (ST1) de commande, qui est monté dans la première branche du diviseur de tension en série avec la première résistance (R1).

4. Circuit suivant la revendication 3, **caractérisé en ce que** le. premier transistor (ST1) de commande a la même tension de seuil que le deuxième transistor (AT2) de travail.

5. Circuit suivant la revendication 3 ou 4, **caractérisé en ce que** la borne de drain du premier transistor (ST1) de commande et l'électrode de grille du premier transistor (ST1) de commande sont reliées.

6. Circuit suivant l'une des revendications 2 à 5, **caractérisé en ce que** la deuxième unité de circuit a au moins un deuxième transistor (ST2) de commande, qui est monté dans la deuxième branche du diviseur de tension en parallèle avec la deuxième résistance (R2).

7. Circuit suivant la revendication 6, **caractérisé en ce que** le deuxième transistor (ST2) de commande est un transistor à canal p.

8. Circuit suivant l'une des revendications 2 à 5, **caractérisé en ce que** la deuxième unité de circuit a au moins un deuxième transistor (ST2) de commande, qui est monté dans la première branche du diviseur de tension en série avec la première résistance (R1).

9. Circuit suivant la revendication 8, **caractérisé en ce que** le deuxième transistor (ST2) de commande est un transistor à canal n.

10. Circuit suivant l'une des revendications 1 à 9, **caractérisé en ce que** la borne (R) de tension de régulation est reliée en outre par un condensateur (Ck) à l'électrode de grille du deuxième transistor (AT2) de travail.

11. Circuit suivant l'une des revendications 1 à 10, **caractérisé en ce qu'**il est prévu un circuit (BT1, BT2) de polarisation de l'électrode de grille du premier transistor (AT1) de travail.

12. Circuit suivant la revendication 11, **caractérisé en ce que** le circuit de polarisation a au moins deux transistors (BT1, BT2) à effet de champ en cascade, dont les électrodes de grille sont reliées aux électrodes de grille des premier et deuxième transistors (AT1, AT2) de travail.
